# EUROPÄISCHE PATENTANMELDUNG

(11) **EP 0 962 983 A2**
(43) Veröffentlichungstag der Anmeldung: **08.12.1999**
(21) Anmeldenummer: 99201717.8
(22) Anmeldetag: 31.05.1999
(51) Int. Cl.: H01L 27/146, G01T 1/29

(54) **Röntgenbildsensor**

(30) Priorität: 06.06.1998 DE 19825450
(71) Anmelder: Philips Patentverwaltung GmbH, 22335 Hamburg (DE); Koninklijke Philips Electronics N.V., 5621 BA Eindhoven (NL)
(72) Erfinder: Dr. Ulrich Schiebel, 22335 Hamburg (DE); Dr. Andreas Brauers, 22335 Hamburg (DE)
(74) Vertreter: Peuckert, Hermann, Dipl.-Ing.

(57) **Zusammenfassung**

Die Erfindung betrifft einen Röntgenbildsensor mit schichtweise übereinander angeordnet einer Sammelelektrode (11), einer Fotoleiterschicht (12) und einer Vorspannungselektrode (8) zum Anlegen einer Vorspannung über der Fotoleiterschicht (12) und mit mehreren auf der Sammelelektrode (11) angeordneten, für Röntgenstrahlung (4) empfindlichen Sensorelementen (7). Um bei einem solchen Röntgenbildsensor eine integrierte Möglichkeit zur ortsaufgelösten Röntgenstrahlendosis-Messung zu schaffen, um insbesondere die Belichtung steuern zu können, ist erfindungsgemäß vorgesehen, daß die Vorspannungselektrode (8) in mehrere Sektoren unterteilt ist und daß Mittel (13) vorgesehen sind zur Messung der Röntgenstrahlendosis in den Sektoren.

## Beschreibung

Die Erfindung betrifft einen Röntgenbildsensor nach dem Oberbegriff des Anspruchs 1 sowie eine Röntgeneinrichtung nach dem Oberbegriff des Anspruchs 4.

Ein derartiger Röntgenbildsensor und eine derartige Röntgeneinrichtung sind aus der WO 97/10616 (= PHN 15.435) bekannt. Derartige dynamische Röntgenbildsensoren, mit denen Röntgenaufnahmen in dichter zeitlicher Folge durchgeführt werden sollen, weisen eine Sensormatrix auf, bei der die Sensorelemente in Zeilen- und Spaltenweise angeordnet sind. Für jeden Bildpunkt ist ein Sensorelement vorgesehen, der ein Schaltelement, eine Kapazität sowie einen Fotosensor umfaßt. Die typischerweise 2000 x 2000 Schaltelemente werden auf einem gemeinsamen dielektrischen Substrat (z.B. Glas) in Dünnschichttechnik realisiert (beispielsweise in Form von Dünnfilm-Fetdeffekttransistoren). Die Fotosensoren werden durch eine durchgehende, das ganze Bildfeld bedeckende Fotoleiterschicht, eine Vorspannungselektrode, die auf die Fotoleiterschicht aufgebracht ist, und für jedes Bildelement eine gesonderte, auf der anderen Seite der Fotoleiterschicht befindliche Sammelelektrode gebildet. Wenn im Betriebszustand der Röntgenbildsensor von Röntgenstrahlung getroffen wird, werden in der Fotoleiterschicht Ladungsträger erzeugt, die unter dem Einfluß eines elektrischen Feldes, das mittels einer an die Vorspannungselektrode angeschlossenen Vorspannungsquelle erzeugt wird, durch den Fotoleiter zu den Sammelelektroden fließen. Dadurch werden die mit den Sammelelektroden verbundenen Kapazitäten aufgeladen, und diese können danach ausgelesen werden.

Bei der bekannten Anordnung ist die Vorspannungselektrode ganzflächig ausgestaltet und dient ausschließlich zum Anlegen einer Vorspannung über den Fotoleiter. Es ist jedoch wünschenswert, mit einem solchen Röntgenbildsensor auch die Möglichkeit der Dosimeterie zu haben, d.h. die Röntgenstrahlendosis hinter dem Patienten zu messen und diese Information beispielsweise zur Belichtungssteuerung zu nutzen. Insbesondere ist es wünschenswert, diese Dosimetrieeinrichtung in den Röntgenbildsensor mit zu integrieren, um nicht ein separates, ausschließlich zur Dosimetrie verwendetes Bauteil in den Strahlengang einbringen zu müssen, was beispielsweise bei flachen, auf Dünnschicht-Arraytechnologie beruhenden Röntgenbilddetektoren nicht möglich ist.

Der Erfindung liegt demnach die Aufgabe zugrunde, bei dem eingangs genannten Röntgenbildsensor die Möglichkeit zur Dosimetrie zu schaffen und eine Röntgeneinrichtung mit einem solchen Röntgenbildsensor anzugeben.

Diese Aufgabe wird erfindungsgemäß durch den in Anspruch 1 angegebenen Röntgenbildsensor gelöst. Durch die erfindungsgemäße Unterteilung der Vorspannungselektrode in mehrere Sektoren kann die Röntgenstrahlendosis ortsaufgelöst gemessen werden. Die Größe der einzelnen Sektoren kann dabei abhängig von der gewünschten Auflösung gewählt werden. Erfindungsgemäß wird dabei die Eigenschaft eines solchen Röntgenbildsensors ausgenutzt, daß bei Anlegen einer Vorspannung an den Fotoleiter Elektron-Loch-Paare entstehen und daß die einen Ladungsträger zur Sammelelektrode und damit zu den Sensorelementen wandern, wo die Röntgenbelichtung ausgelesen wird, während die anderen Ladungsträger zur Vorspannungselektrode wandern, wo dann die Röntgenstrahlendosis ausgelesen werden kann.

Vorteilhafterweise werden gemäß Anspruch 2 mit geeigneten Mitteln die Ströme an den einzelnen Sektoren der Vorspannungselektrode gemessen, wozu bereits einfache Meßverstärker ausreichend sein können.

In einer vorteilhaften Ausgestaltung des Röntgenbildsensors sind die Sensorelemente gemäß Anspruch 3 als Sensormatrix in Zeilen und Spalten angeordnet, insbesondere in Form eines Dünnschicht-Arrays.

Die Erfindung betrifft auch eine Röntgeneinrichtung mit einem solchen erfindungsgemäßen Röntgenbildsensor. Dieser kann vorteilhafterweise zur Steuerung der Belichtung eingesetzt werden, wozu beispielsweise mittels der gemessenen Röntgendosis die Röntgenstrahlenquelle und/oder eine Röntgenstrahlenblende (oder z.B. ein im Strahlengang befindliches Röntgenstrahlen-Dämpfungsglied) gesteuert wird. Je nach Ausgestaltung des Röntgenbildsensors, insbesondere je nach Ausgestaltung der Fotoleiterschicht, kann dieser so angeordnet sein, daß die Vorspannungselektrode entweder dem zu durchstrahlenden Objekt zugewandt oder von diesem abgewandt angeordnet ist, um die Eingangsröntgendosis des Röntgenbildsensors zu messen.

Die Erfindung wird nachfolgend anhand der Zeichnung erläutert. Es zeigen:
Fig. 1 eine schematische Darstellung einer Röntgeneinrichtung gemäß der Erfindung und
Fig. 2 eine schematische Querschnittdarstellung eines erfindungsgemäßen Röntgenbildsensors.

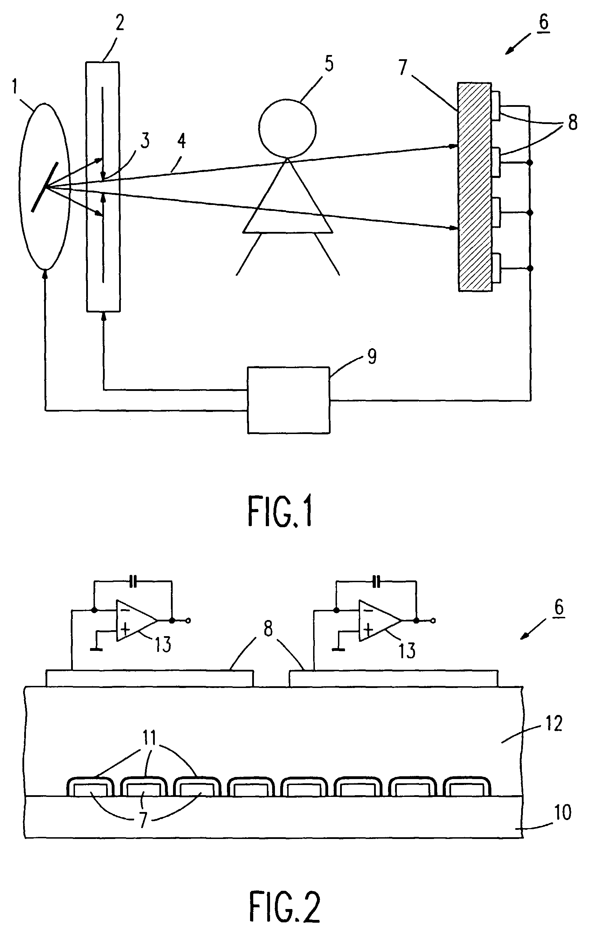

Bei der in Fig. 1 gezeigten Röntgeneinrichtung wird die mittels der Röntgenröhre 1 erzeugte Röntgenstrahlung mittels einer Röntgenstrahlenblende 2 derart eingeblendet, daß nur durch die Öffnung 3 Röntgenstrahlung 4 auf den Patienten 5 fallen kann. Die den Patienten 5 durchtretende Röntgenstrahlung wird mittels eines Röntgenbilddetektors 6 gemessen und dort in ein Röntgenbild umgewandelt. Der Röntgenbilddetektor 6 weist dazu einen erfindungsgemäßen Röntgenbildsensor mit einer Anzahl von als Sensormatrix angeordneten Sensorelementen 7 auf, die jeweils die Belichtung ortsabhängig messen und woraus jeweils die Helligkeit eines einzelnen Bildpunktes (Pixels) des Röntgenbildes ermittelt wird. Auf der vom Patienten 5 abgewandten Seite weist der Röntgenbildsensor die erfindungsgemäß in einzelne Sektoren aufgeteilte Vorspannungselektrode 8 auf, an der die Röntgenstrahlendosis am Eingang des Röntgenbilddetektors 6 indirekt gemessen werden kann. Diese Information wird an eine Belichtungssteuerungseinrichtung 9 weitergegeben, die die Röntgenstrahlenquelle 1 oder die Röntgenstrahlenblende 2 steuern kann, um somit die Belichtung zu beeinflussen. Da bei der erfindungsgemäßen Röntgeneinrichtung die Dosismessung quasi kontinuierlich erfolgen kann, Meßwerte der Röntgenstrahlendosis somit in sehr kurzen Zeitabständen zur Verfügung stehen, kann insbesondere in der Anfangsphase der Bildgebung die Belichtung entsprechend gesteuert werden, um ein Röntgenbild mit der gewünschten Bildqualität mit der geringstmöglichen Strahlungsbelastung für den Patienten zu erhalten.

In Fig. 2 ist schematisch ein erfindungsgemäßer Röntgenbildsensor gezeigt. Auf einem beispielsweise aus Glas bestehenden Substrat 10 sind die einzelnen Sensorelemente 7 aufgebracht, die jeweils von einer Sammelelektrode 11 bedeckt sind, Darüber befindet sich die Fotoleiterschicht 12, auf deren Oberfläche sich die in Sektoren unterteilte Vorspannungselektrode 8 befindet. Abgesehen von der Funktionsweise der Dosimeterie soll hier auf die allgemeine Funktionsweise eines solchen Röntgenbildsensors ebensowenig eingegangen werden wie auf eine genaue Beschreibung des internen Aufbaus sowie der verwendeten Materialien. Dazu wird auf den genannten Stand der Technik verwiesen, dessen Inhalt hiermit ausdrücklich mit umfaßt werden soll.

Für jeden Sektor der Vorspannungselektrode 8 ist ein einzelner Meßverstärker 13 vorgesehen, mit dem jeweils der durch die Vorspannungselektrode 8 fließende Strom bei Belichtung des Röntgenbildsensors gemessen werden kann. Da diese Ströme abhängig sind von der Intensität der auf den Röntgenbildsensor treffenden Röntgenstrahlung, wird dadurch quasi indirekt die Röntgenstrahlendosis am Eingang des Röntgenbilddetektors gemessen. Der erfindungsgemäße Röntgenbildsensor stellt somit eine einfache Lösung für einen Röntgenbildsensor mit integrierter Dosimeetrieeinrichtung dar. Diese Lösung ist auch unabhängig von der Ausgestaltung der Sensormatrix, insbesondere von dem Layout dieser Matrix. Isolationsschichten wie bei dem bekannten Röntgenbildsensor zwischen der Vorspannungselektrode und dem Fotoleiter werden dabei ebenfalls nicht benötigt.

Da die Röntgenstrahlendosis ortsabhängig gemessen werden kann, ist es auch möglich, mittels eines dynamischen Röntgendämpfungsgliedes zwischen Röntgenstrahlenquelle und Patient die Röntgenstrahlendosis ortsabhängig zu steuern, wozu vorzugsweise die Ortsauflösung der Dosimetrieeinrichtung der Ortsauflösung des Dämpfungsgliedes entsprechen sollte.

## Patentansprüche

1. Röntgenbildsensor mit schichtweise übereinander angeordnet einer Sammelelektrode (11), einer Fototeiterschicht (12) und einer Vorspannungselektrode (8) zum Anlegen einer Vorspannung über der Fotoleiterschicht (12) und mit mehreren auf der Sammelelektrode (11) angeordneten für Röntgenstrahlung (4) empfindlichen Sensorelementen (7),
dadurch gekennzeichnet,
daß die Vorspannungselektrode (8) in mehrere Sektoren unterteilt ist und daß Mittel (13) vorgesehen sind zur Bestimmung der Röntgendosis in diesen Sektoren.

2. Röntgenbildsensor nach Anspruch 1,
dadurch gekennzeichnet,
daß die Mittel (13) ausgestaltet sind zur Messung der in den Sektoren fließenden Ströme bei Belichtung des Röntgenbildsensors.

3. Röntgenbildsensor nach Anspruch 1,
dadurch gekennzeichnet,
daß die Sensorelemente (7) als Sensormatrix in Zeilen und Spalten angeordnet sind.

4. Röntgeneinrichtung mit einer Röntgenstrahlenquelle (1) zur Erzeugung von ein Objekt (5) durchleuchtender Röntgenstrahlung (4) und mit einem Röntgenbilddetektor (6) zur Erzeugung eines Röntgenbildes,
dadurch gekennzeichnet,
daß der Röntgenbilddetektor (6) einen Röntgenbildsensor nach Anspruch 1 aufweist.

5. Röntgeneinrichtung nach Anspruch 4,
dadurch gekennzeichnet,
daß eine Belichtungssteuerungseinrichtung (9) vorgesehen ist zur Steuerung der Röntgenstrahlenquelle (1) und/oder einer zwischen Röntgenstrahlenquelle (1) und Objekt (5) angeordneten Röntgenstrahlenblende (2) und/oder einer Röntgenstrahlen-Dämpfungseinrichtung mittels der vom Röntgenbildsensor gemessenen Röntgendosis.
